# EUROPEAN PATENT APPLICATION

(11) **EP 4 752 574 A1**
(43) Date of publication of application: **03.06.2026**
(21) Application number: 24848661.5
(22) Date of filing: 30.05.2024
(51) Int. Cl.: G01R 31/34, G01R 31/72, H02K 5/128, H02P 29/024

(54) **MACHINE LEARNING DEVICE, INSULATION STATE DIAGNOSIS DEVICE, MACHINE LEARNING METHOD, MACHINE LEARNING PROGRAM, INSULATION STATE DIAGNOSIS METHOD, AND INSULATION STATE DIAGNOSIS PROGRAM**

(30) Priority: 02.08.2023 JP 2023126445
(71) Applicant: Nikkiso Co., Ltd., Tokyo 150-6022 (JP)
(72) Inventor: EGUCHI Masaaki, Higashimurayama-shi, Tokyo 189-8520 (JP)
(74) Representative: MFG Patentanwälte Meyer-Wildhagen Meggle-Freund Gerhard PartG mbB
(86) International application number: PCT/JP2024/019865
(87) International publication number: WO 2025/028000

(57) **Abstract**

The present invention provides a machine learning device capable of diagnosing an insulation state of a winding without stopping a canned motor pump. A machine learning device 4 generates a training model 6 to be used by an insulation state diagnosis device 5 for diagnosing an insulation state of a winding 31 of a stator 23 used in a canned motor pump 2. The machine learning device 4 trains the training model 6 to learn a correlation between input data and information on diagnosis of the insulation state of the winding by inputting training data including at least the input data into the training model, the input data being unprocessed or at least partially preprocessed data on a voltage value and current value supplied to a motor part 20, a temperature of the winding 31 of the stator 23 or a correlated temperature, temperature difference, or pressure, and an inflow temperature and flow rate of a working fluid in a pump part 10.

## Description

### TECHNICAL FIELD

The present invention relates to a machine learning device, an insulation state diagnosis device, a machine learning method, a machine learning program, an insulation state diagnosis method, and an insulation state diagnosis program, which are suitable for diagnosing an insulation state of a winding wire of a motor section of a canned motor pump including the motor section and a pump section.

### BACKGROUND ART

In a canned motor pump, a rotor of a motor section that drives a pump section is housed in a can filled with handling liquid in the pump section. A stator of the motor section is housed in a motor housing disposed in the outer periphery of the can and functioning as a casing.

In the canned motor pump described above, output of a motor is set based on an allowable temperature of a stator coil. That is, since the periphery of the rotor of the canned motor pump is filled with the handling liquid, the rotor is quickly cooled. For this reason, a target of heat generation in the canned motor pump is mainly a stator side, on which a coil end has the highest temperature. Thus, the output of the motor and a liquid temperature have been specified such that the temperature of the coil end does not exceed the allowable temperature.

In general, the canned motor pump is configured to guide a part of the handling liquid into the can in which the rotor is disposed, lubricate and cool a bearing, and, after absorbing the heat of the motor section (the rotor and the like), return the handling liquid to the pump section.

However, the canned motor pump is often used in a plant that handles high-temperature handling liquid. Thus, when the high-temperature handling liquid is introduced into the can, a winding wire of the motor section has temperature higher than the handling liquid temperature and is easily exposed to temperature equal to or higher than an allowable range for heat resistant insulation. For this reason, the motor section of the canned motor pump is subject to concern about insulation deterioration of the winding wire due to long-term use under a high-temperature environment.

The winding wire needs to be replaced when the insulation deterioration of the winding wire worsens. However, since the stator is sealed between the can and the motor housing, the replacement of the winding wire of the stator involves, for example, disassembly of the sealed motor section. Since such disassembly work requires considerable cost and man-hours, it is necessary to appropriately determine the life of the winding wire, that is, an insulation state of the winding wire.

Thus, in the related art, in order to perform deterioration diagnosis for the winding wire, the canned motor pump is stopped and insulation resistance and inter-terminal resistance of the winding wire are periodically measured and compared with normal values and measurement values in the past to perform tendency management for the insulation state (see Patent Document 1).

### CITATION LIST

### Patent Literature

Patent Document 1: JP 2010-256348A

### SUMMARY OF INVENTION

### Technical Problem

However, in order to perform the tendency management for the insulation state of the winding wire, it is necessary to stop the canned motor pump to measure resistance values (insulation resistance and inter-terminal resistance). It is difficult to frequently stop the canned motor pump during a plant operation.

The present invention has been devised in view of the circumstances described above and a main object of the present invention is to provide a machine learning device, an insulation state diagnosis device, a machine learning method, a machine learning program, an insulation state diagnosis method, and an insulation state diagnosis program that make it possible to diagnose an insulation state of a winding wire without stopping a canned motor pump.

### Solution to Problem

A machine learning device in an embodiment according to the present invention:
wherein a canned motor pump includes, a motor section, and a pump section driven by the motor section,
the motor section including, a rotor capable of rotating centering on a shaft, a stator facing the rotor via a gap, and a tubular can forming, on an inner side, a rotor chamber that houses the rotor and forming, on an outer side, a stator chamber that houses the stator in conjunction with a motor housing,
the machine learning device generating a learning model used for an insulation state diagnosis device for diagnosing an insulation state of a winding wire of the stator used in the canned motor pump that circulates a part of handling liquid in the pump section to the rotor chamber, the machine learning device including:
   a learning data acquirer that sets, as input data, data of a voltage value and a current value supplied to the motor section, data of temperature of a winding wire of the stator or temperature, a temperature difference, or pressure correlated with the temperature of the winding wire, and data of an inflow temperature and a flow rate of the handling liquid, the data being unprocessed data or at least partially preprocessed data, and acquires a plurality of sets of learning data including at least the input data;
   a machine learner that inputs the learning data to the learning model to cause the learning model to learn a correlation between the input data and diagnosis information of the insulation state of the winding wire; and
   a learned model storage that stores the learning model learned by the machine learner.

An insulation state diagnosis device in an embodiment according to the present invention is
an insulation state diagnosis device for diagnosing an insulation state of the winding wire of the stator used in the canned motor pump using a learning model generated by the machine learning device described above, the insulation state diagnosis device including:
an input data acquirer that acquires input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid, the data being unprocessed data or at least partially preprocessed data; and
an inferer that inputs the input data acquired by the input data acquirer to the learning model and infers diagnosis information of the insulation state of the winding wire of the stator.

A machine learning method in an embodiment according to the present invention is
a machine learning method of learning a learning model used for an insulation state diagnosis device that diagnoses a canned motor pump including, a motor section, and a pump section driven by the motor section,
the motor section including, a rotor capable of rotating centering on a shaft, a stator facing the rotor via a gap; and a tubular can forming, on an inner side, a rotor chamber that houses the rotor and forming, on an outer side, a stator chamber that houses the stator in conjunction with a motor housing,
the insulation state diagnosis device being for diagnosing an insulation state of a winding wire of the stator used in the canned motor pump that circulates a part of handling liquid in the pump section to the rotor chamber, the machine learning method including:
   a learning data acquisition step of setting, as input data, data of a voltage value and a current value supplied to the motor section, data of temperature of a winding wire of the stator or temperature, a temperature difference, or pressure correlated with the temperature of the winding wire, and data of an inflow temperature and a flow rate of the handling liquid, the data being unprocessed data or at least partially preprocessed data, and acquiring a plurality of sets of learning data including at least the input data;
   a machine learning step of inputting the learning data to the learning model to cause the learning model to learn a correlation between the input data and diagnosis information of the insulation state of the winding wire; and
   a learned model storing step of storing the learning model learned by the machine learning step in a learned model storage.

A machine learning program in an embodiment according to the present invention causes
a computer to execute the steps included in the machine learning method.

An insulation state diagnosis method in an embodiment according to the present invention is
an insulation state diagnosis method of diagnosing an insulation state of the winding wire of the stator used in the canned motor pump using a learning model generated by the machine learning device described above, the insulation state diagnosis method including:
an input data acquisition step of acquiring input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid, the data being unprocessed data or at least partially preprocessed data; and
an inferring step of inputting the input data acquired by the input data acquisition step to the learning model and inferring diagnosis information of the insulation state of the winding wire of the stator.

An insulation state diagnosis program in an embodiment according to the present invention causes
a computer to execute the steps included in the insulation state diagnosis method.

### Advantageous Effects of Invention

According to the present invention, it is possible to provide a machine learning device, an insulation state diagnosis device, a machine learning method, a machine learning program, an insulation state diagnosis method, and an insulation state diagnosis program that make it possible to diagnose an insulation state of a winding wire without stopping a canned motor pump.

### BRIEF DESCRIPTION OF DRAWINGS

[FIG. 1] This is a schematic configuration diagram illustrating an insulation state diagnosis device applied to a canned motor pump.
[FIG. 2] This is a cross-sectional view illustrating an example of the canned motor pump.
[FIG. 3] This is a block diagram illustrating an example of a machine learning device.
[FIG. 4] This is a flowchart illustrating an example of a machine learning method by a machine learning device according to a first embodiment.
[FIG. 5] This is a block diagram illustrating an example of an insulation state diagnosis device.
[FIG. 6] This is a flowchart illustrating an example of an insulation state diagnosis method by an insulation state diagnosis device according to the first embodiment.
[FIG. 7] This is a cross-sectional view illustrating another example of the canned motor pump.
[FIG. 8A] This is a block diagram illustrating an example of a machine learning device applied to the canned motor pump illustrated in FIG. 7.
[FIG. 8B] This is a block diagram illustrating an example of an insulation state diagnosis device applied to the canned motor pump illustrated in FIG. 7
[FIG. 9] This is a flowchart illustrating an example of a machine learning method by a machine learning device according to a second embodiment.
[FIG. 10] This is a flowchart illustrating an example of an insulation state diagnosis method by an insulation state diagnosis device according to the second embodiment.

### DESCRIPTION OF EMBODIMENTS

Embodiments of the present invention are described below with reference to the drawings.

### (First Embodiment)

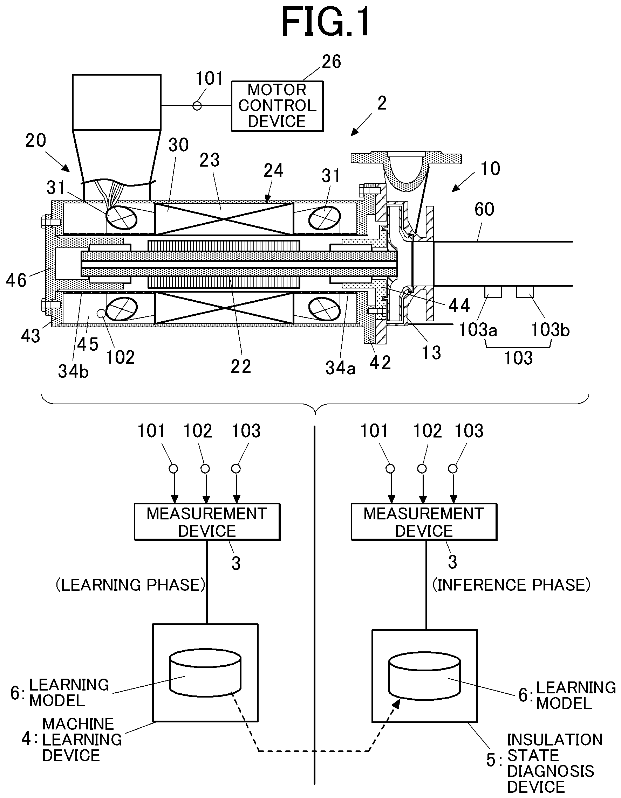

FIG. 1 is a schematic configuration diagram illustrating an insulation state diagnosis system 1 applied to a canned motor pump. A canned motor pump 2 used here is, as an example, a horizontal-type canned motor pump in which a motor axis direction is substantially horizontal. However, the present invention is not limited to the horizontal type and is also applicable to a vertical-type canned motor pump in which a motor axis direction is substantially vertical.

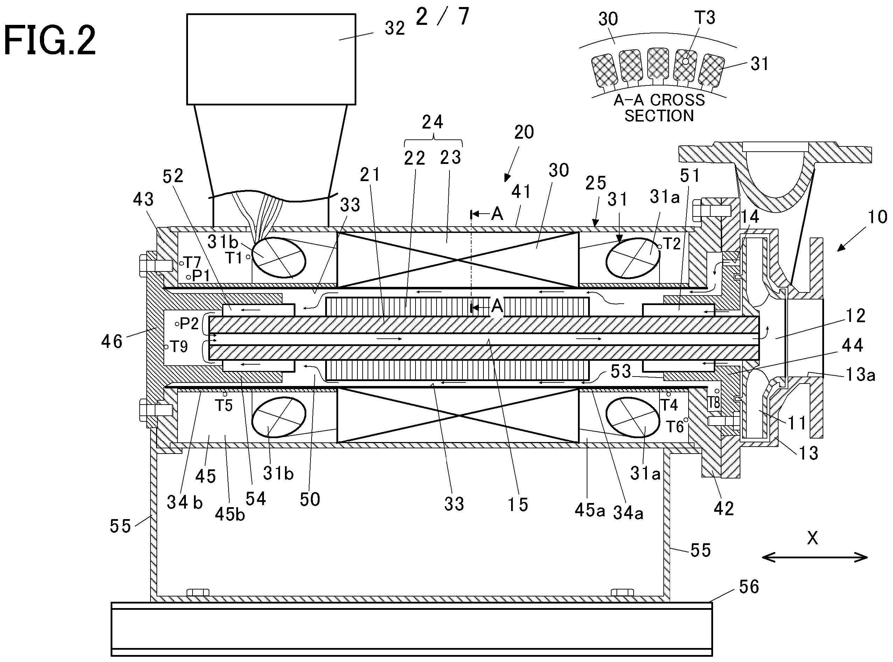

First, an overview of the canned motor pump 2 is described with reference to FIG. 2.

FIG. 2 is a cross-sectional view illustrating a configuration example of the canned motor pump 2 according to the present embodiment. Note that an X direction illustrated in the figure is the motor axis direction. The right side in the figure is the front and the left side in the figure is the rear.

In FIG. 2, the canned motor pump 2 includes a pump section 10 having the configuration of a centrifugal pump and a motor section 20 that drives the pump section 10. The pump section 10 and the motor section 20 are coaxially coupled by a shaft 21 of a motor 24 described below.

The pump section 10 includes an impeller 11 and a pump casing 13 forming a pump chamber 12 that houses the impeller 11. The impeller 11 is coupled to the front end portion of the shaft 21 of the motor 24. Note that, in the present embodiment, a case is described in which the pump section 10 is configured with the centrifugal pump. However, the present invention is not limited to this. The pump section 10 may be configured as a turbo pump such as a mixed flow pump or an axial flow pump.

The motor section 20 includes a motor 24 including a rotor 22 that is fixed to the periphery of the shaft 21 and rotates integrally with the shaft and an annular stator 23 disposed to surround the rotor 22 at a predetermined interval and a motor housing 25 that houses the motor 24.

The stator 23 includes a stator core 30 including teeth arrayed in the circumferential direction on a substantially cylindrical inner circumferential surface and a winding wire (a coil) 31 formed by winding a lead wire on the teeth of the stator core 30. The end of the lead wire of the winding wire 31 is guided into a terminal box 32 extended from an outer cylinder 41 of the motor housing 25 to the radial direction outer side and is connected to a not-illustrated terminal provided in the terminal box 32.

A cylindrical can 33 is disposed in a portion on the inner side of the stator core 30 and the outer side of the rotor 22, that is, between the rotor 22 and the stator 23. The can 33 is fixed in a state of being in contact with the inner circumferential surface of the stator core 30, that is, the distal end surface of the teeth and is disposed at a fixed interval from the outer circumferential surface of the rotor 22.

A cylindrical outer cylinder (a stator band) 41 that houses the motor is provided along the outer circumferential surface of the stator core 30. The can 33 and the outer cylinder 41 are concentrically disposed and are formed substantially equal in the lengths in the axial direction X. Annular plate-shaped end bells 42 and 43 are disposed at both ends of each of the can 33 and the outer cylinder 41. A cylindrical space formed between the can 33 and the outer cylinder 41 is closed by the end bells 42 and 43.

The end bell 42 on the pump section 10 side is coupled to the pump casing 13 by a bolt. A bearing holder 44 that closes a space on the inner side of the can 33 is coupled to the end bell 43 on the side opposite to the pump section 10 by a bolt.

The motor housing 25 that houses the motor 24 is configured with the outer cylinder 41, the end bells 42 and 43 at both the ends, and the bearing holder 44.

A rotor chamber 50 that houses the rotor 22 on the inner side of the can 33 is formed by the can 33, the pump section 10, and the bearing holder 44.

Further, a stator chamber 45 that houses the stator 23 is formed by a cylindrical space partitioned by the outer cylinder 41, the can 33, and the end bells 42 and 43 at both the ends. The stator core 30 is disposed in the substantially center portion in the axial direction of the stator chamber 45. The stator chamber 45 includes, in the front and the rear in the axial direction of the stator core 30, annular coil end housing sections 45a and 45b that house coil ends 31a and 31b.

Note that tubular backup sleeves 34 (34a and 34b) that prevent deformation of the can 33 are applied to the outer circumferential surface of the can 33 facing the coil end housing sections 45a and 45b.

Both ends of the shaft 21 to which the rotor 22 is integrally fixed are supported by bearings 51 and 52. The bearing 51 on the pump section 10 side is held by a bearing section 53 extending from the bearing holder 44 fixed to the end bell 42 behind the pump casing 13 of the pump section 10. The bearing 52 on the side opposite to the pump section 10 is held by a bearing section 54 extending from the bearing holder 46 fixed to the end bell 43. The bearings 51 and 52 are configured with plane bearings positioned by the bearing sections 53 and 54.

The canned motor pump 2 described above is fixed to a support stand 56 by legs 55 fixed to the end bells 42 and 43.

An introduction flow path 14 that guides the handling liquid into the can 33 is formed in the bearing holder 44 fixed behind the pump casing 13 of the pump section 10. A center hole 15 is formed over the entire length of the shaft 21 along the axis thereof. A part of the handling liquid delivered by the impeller 11 becomes internal circulation liquid that circulates in the can 33 as indicated by an arrow in FIG. 2. That is, the part of the handling liquid goes around the back of the impeller 11 and is introduced into the can 33 (the rotor chamber 50) through the introduction flow path 14. The handling liquid introduced into the can 33 (the rotor chamber 50) enters the center hole 15 formed in the shaft from the rear end of the shaft 21 after lubricating and cooling the bearings 51 and 52 and cooling the motor section 20 (the rotor 22 and the like). The handling liquid is returned to a suction side of the pump section 10 via the center hole 15 and delivered to a vortex chamber by the impeller 11.

The insulation state diagnosis system 1 that diagnoses an insulation state of the winding wire 31 of the stator 23 is provided for the canned motor pump 2 having the configuration described above. The insulation state diagnosis system 1 includes, as illustrated in FIG. 1, a measurement device 3, a machine learning device 4, and an insulation state diagnosis device 5.

The measurement device 3 is installed in the canned motor pump 2 or an appropriate place around the canned motor pump 2 and measures physical quantities and state quantities of portions. The measurement device 3 is connected to the machine learning device 4 and used to measure learning data in a learning phase and is connected to the insulation state diagnosis device 5 and used to measure diagnosis data in an inference phase.

Here, as the measurement device 3, a measurement device used in the learning phase and a measurement device used in the inference phase may be the same or may be different. The measurement device 3 includes a motor voltage/current sensor 101, a winding wire heat generation state measurement sensor 102, and a handling liquid measurement sensor 103.

The motor voltage/current sensor 101 measures a motor voltage value and current value supplied to the motor section 20 and, for example, is attached to a power line connecting the motor 24 and a motor control device 26 and measures voltage/current values supplied from the motor control device 26 to the motor 24. Note that the motor voltage/current sensor 101 may be provided on the inside of the motor section 20 or the inside of the motor control device 26.

The motor voltage/current sensor 101 may measure voltage/current values of respective three phases.

The winding wire heat generation state measurement sensor 102 directly or indirectly measures the temperature of the winding wire 31 of the motor 24 (the stator 23). That is, the winding wire heat generation state measurement sensor 102 measures data of the temperature of the winding wire or temperature, a temperature difference, or pressure correlated with the temperature of the winding wire.

When the temperature of the winding wire 31 is directly measured, thermocouples are attached to parts having the highest temperature in the winding wire 31, for example, the coil ends 31a and 31b to measure the temperature. A thermocouple may be attached to the winding wire 31 on the inside of the stator core 30 to measure the winding wire temperature.

When the temperature of the winding wire 31 is indirectly measured, thermocouples may be attached to the backup sleeves 34a and 34b, the end bells 42 and 43, or the bearing holders 44 and 46, on which a state (an amount and temperature) of radiant heat from the winding wire 31 or internal circulation liquid act, to measure the surface temperature of the parts.

Here, an example is described above in which the winding wire heat generation state measurement sensor 102 detects the temperature using the thermocouples. However, another contact sensor such as a thermistor or a resistance thermometer may be used or a noncontact sensor such as an infrared sensor may be used.

Pressure P1 in the stator chamber 45 may be measured in order to indirectly measure the temperature of the winding wire 31.

The handling liquid measurement sensor 103 is configured with, for example, an inflow temperature sensor 103a and a flow rate sensor 103b provided in an inflow pipe 60 connected to an inflow port 13a of the pump casing 13.

The inflow temperature sensor 103a measures the temperature of the handling liquid flowing into the pump section 10 and, for example, measures fluid temperature in the inflow pipe 60 with a temperature sensor for piping in which a resistance thermometer is used as a temperature detection element. The flow rate sensor 103b measures an inflow amount of the handling liquid flowing into the pump section 10. Various sensors such as an ultrasonic type, an electromagnetic type, a Karman vortex shedding type, a turbine type, a variable area type, a thermal type, and a differential pressure type can be used.

The measurement device 3 is configured to measure physical quantities and state quantities of sections and output measurement values of the physical quantities and the state quantities to the machine learning device 4 or the insulation state diagnosis device 5. The measurement values measured by the measurement device 3 may be pinpoint measurement values measured at predetermined timing, may be a discrete group of measurement values over time measured at each predetermined measurement cycle in a predetermined period, or may be continuous measurement values measured in a predetermined period.

The machine learning device 4 operates as a subject in the learning phase and generates, with machine learning, a learning model 6 used when an insulation state of the winding wire 31 is diagnosed. As the machine learning, both of "supervised learning" and "unsupervised learning" can be adopted. The "supervised learning" is adopted in the first embodiment and the "unsupervised learning" is adopted in a second embodiment.

The insulation state diagnosis device 5 operates as a subject in the inference phase and diagnoses (infers) an insulation state of the winding wire 31 from the measurement values measured by the measurement device 3 using the learned learning model 6 generated by the machine learning device 4.

### (Machine learning device)

The machine learning device 4 is configured with a general-purpose or dedicated computer. The computer may be either a stationary computer or a portable computer, may be a client computer, or may be a server computer or a cloud computer.

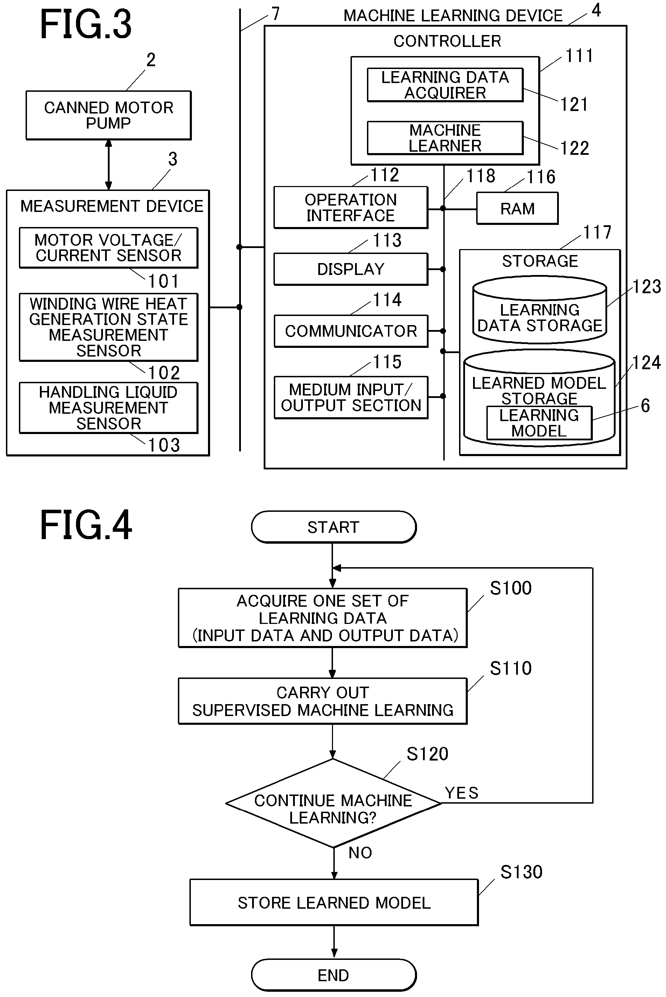

The machine learning device 4 includes, as illustrated in FIG. 3, a controller 111, an operation interface 112, a display 113, a communicator 114, a medium input/output section 115, a RAM 116, a storage 117, and a bus 118. The sections of the machine learning device 4 are connected via the bus 118.

The controller 111 is configured with an arithmetic processing device (a processor such as a CPU, an MPU, or a DSP) and reads and executes a program loaded in the RAM 116 and performs various kinds of arithmetic processing to control operations of the sections of the machine learning device 4.

Note that the controller 111 may include a plurality of processors and the plurality of processors may execute various kinds of processing in the present embodiment. In this case, the plurality of processors may be involved in common processing or the plurality of processors may independently execute different kinds of processing in parallel.

The operation interface 112 is configured with, for example, a keyboard, a mouse, a tenkey pad, or an electronic pen and functions as an input section.

The display 113 is configured with, for example, a liquid crystal display, an organic EL display, an electronic paper, or a projector and functions as an output section.

The operation interface 112 and the display 113 may be integrally configured like a touch panel display.

The communicator 114 is connected to the measurement device 3 via a network 7 and functions as a communication interface that transmits and receives various data (measurement data and the like).

The medium input/output section 115 is configured with, for example, a DVD drive, a CD drive, or a USB port and reads data from and writes data in a medium (a non-transitory storage medium) such as a DVD, a CD, or a USB.

The RAM 116 is configured with a volatile memory (a DRAM, an SRAM, or the like) that stores various data and programs and functions as a main memory.

The storage 117 is configured with a storage device such as a HDD or an SSD and stores various data necessary for execution of an operating system or programs.

Note that the programs may be stored in the storage 117 instead of the RAM 116. The programs may be recorded in a medium in an installable file format or an executable file format and provided to the machine learning device 4 via the medium input/output section 115. The programs may be provided to the machine learning device 4 by being downloaded through the network 7 via the communicator 114.

The controller 111 executes a machine learning program (not illustrated) to function as a learning data acquirer 121 and a machine learner 122.

The storage 117 includes a learning data storage 123 functioning as a database that stores a plurality of sets of learning data acquired by the learning data acquirer 121 and a learned model storage 124 functioning as a database that stores the learned learning model 6 subjected to machine learning.

Note that, in the present embodiment, a case is described in which the learning data storage 123 and the learned model storage 124 are provided in a single storage device. However, the learning data storage 123 and the learned model storage 124 may be configured as separate storage devices.

The learning data acquirer 121 functions as an interface unit that acquires learning data including at least input data via the communicator 114 and the network 7 or via the medium input/output section 115. The learning data acquirer 121 also receives input operation of an operator via the operation interface 112 to acquire the learning data.

The input data included in the learning data is acquired by attaching sensors (the motor voltage/current sensor 101, the winding wire heat generation state measurement sensor 102, and the handling liquid measurement sensor 103) serving as the measurement device 3 to the sections of the canned motor pump 2 serving as a test machine and connecting the measurement device 3 to the machine learning device 4 via the network 7. Output data included in the learning data can be automatically acquired in association with the input data if an insulation state of the winding wire at the time of input data acquisition can be specified using an image analysis or the like. However, the output data may be acquired by operating the operation interface 112 in association with the input data.

Note that, when the learning data is separately acquired and stored in an external device, the learning data acquirer 121 may acquire the learning data via the medium input/output section 115 or the communicator 114 and the network 7.

When learning data is collected from the canned motor pump 2 serving as the test machine, as the canned motor pump 2 serving as the test machine, a pump having the same configuration as an actual machine that diagnoses an insulation state of the winding wire is preferably used. However, when it is recognized that measurement data does not rely on a model, a similar canned motor pump may be used or a test device simulating the canned motor pump may be used.

The learning data storage 123 is a database that stores a plurality of sets of learning data acquired by the learning data acquirer 121.

Therefore, the learning data stored in the learning data storage 123 is learning data obtained by loading input data measured by the measurement device 3 and output data input from the operation interface 112 or existing learning data collected in advance.

The learned model storage 124 is a database that stores the learned learning model 6 generated by the machine learner 122. The learning model 6 stored in the learned model storage 124 is provided to the insulation state diagnosis device 5 via any communication network or storage medium.

The machine learner 122 carries out machine learning using the learning data stored in the learning data storage 123. The machine learner 122 sequentially inputs a plurality of sets of learning data to the learning model 6 to cause the learning model 6 to learn a correlation between input data included in the learning data and insulation information of the winding wire and generates a learned model. There are various methods of generating the learned model. However, for example, a neural network is desirably adopted as a specific method of supervised learning by the machine learner 122.

Here, the learning data includes, as the input data, at least data of a voltage value and a current value supplied to the motor section 20 (the motor 24), data of the temperature of the winding wire 31 of the stator 23 or temperature, a temperature difference, or pressure correlated with the temperature of the winding wire 31, and data of an inflow temperature and a flow rate of the handling liquid. The input data may include data other than the data described above. In that case, the input data desirably includes data that can be collected without stopping the canned motor pump and has a correlation with an insulation state of the winding wire.

Here, an example is described in which, as the input data, raw data (unprocessed data) of the data of the voltage value and the current value supplied to the motor section 20 (the motor 24), the data of the temperature of the winding wire 31 of the stator 23 or the temperature, the temperature difference, or the pressure correlated with the temperature of the winding wire 31, and the data of the inflow temperature and the flow rate of the handling liquid are used. However, the input data is not limited to this. Data obtained by applying preprocessing to at least a part of the data may be used as the input data (the input data acquired by the learning data acquirer 121 and the input data stored in the learning data storage 123 may be data obtained by applying the preprocessing to at least a part of the data).

The preprocessing for the data includes, for example, removal of a data outlier point and data standardization. The preprocessing for the data includes processing generally performed in machine learning, such as type conversion, missing value processing (removal and interpolation), and scaling. The preprocessing may include at least one filtering process for the input data to satisfy a predetermined standard.

In the case of the "supervised learning", the learning data further includes, as output data (teacher data) associated with the input data, diagnosis information representing an insulation state of the winding wire at the time of the acquisition of the input data, for example, diagnosis information representing which state among a plurality of states the insulation state is.

Here, the diagnosis information is information obtained by evaluating the insulation state of the winding wire 31 (information obtained by evaluating a phenomenon for determining insulation deterioration) and includes at least one of, for example,
(1) information obtained by determining whether adhesion of the handling liquid is present in the entire winding wire 31 (this is because, since chemical liquid or liquid having conductivity is often used as the handling liquid, when the can 33 is broken and the handling liquid flows into the stator chamber 45, the handling liquid adheres to the winding wire 31 to induce insulation deterioration),
(2) information diagnosed from presence or absence of burning/discoloration in a state of the winding wire 31, that is, information determined from presence or absence of a phenomenon in which a coil bundle is burned in an annular shape or presence or absence of a phenomenon in which a coil bundle at an inlet (a lead port) of the winding wire 31 is burned (this is because, when a scratch occurs in the winding wire 31, the coil bundle generates heat and is burned in an annular shape and, when a large surge voltage is applied on supplied voltage, the winding wire 31 is damaged at a power supply inlet (a lead wire side) and burning occurs in the coil bundle at the winding wire inlet),
(3) information determined from presence or absence of a voltage imbalance or presence or absence of one phase burning due to the voltage imbalance (a phenomenon that can occur because of a power supply abnormality), and
(4) information determined from presence or absence of a discoloration degree or a heated trace of the entire winding wire 31 (a phenomenon that can occur because of overheat).

When the presence or absence of an abnormality is diagnosed as the insulation state of the winding wire 31, the diagnosis information is constituted as information representing whether the insulation state is normal or abnormal. The diagnosis information in this case may be defined as "0" when the insulation state of the winding wire is a normal state and may be defined as "1" when the insulation state of the winding wire is an abnormal state.

An abnormality concerning the insulation of the winding wire 31 may be obtained by classifying a deterioration degree (an abnormality degree) of insulation in a plurality of levels. In this case, the diagnosis information is represented by multiple values and may be set to "0" when the insulation state is normal, set to "1" when the deterioration degree of the insulation is a low level abnormality, and set to "2" when the deterioration degree of the insulation is a high level abnormality.

The abnormality is not only a posterior abnormality, occurrence of which is found at a diagnosis time point, and may be an abnormality that is in an allowable range of determining normal at the diagnosis time point but includes a sign of an abnormality, occurrence of which is predicted in future.

Here, a correlation between the input data (the data of the motor voltage/current values, the data of the temperature of the winding wire or the temperature, the temperature difference, or the pressure correlated with the temperature of the winding wire, and the data of the inflow temperature and the flow rate of the handling liquid) included in the learning data and the diagnosis information of the insulation state of the winding wire is described.

The voltage value and the current value supplied to the motor section 20 are applied from the motor control device 26 to the motor 24 when the motor section 20 is driven to rotate and change according to output of the motor 24.

### (Correlation between an applied voltage and an insulation state)

An applied voltage is necessary as basic information for performing various factor analyses. For example, when voltage imbalance (unbalance of three phase voltages) increases, current unbalance increases accordingly and a phenomenon in which only one phase is burned occurs. By measuring a voltage waveform, it is also possible to check presence or absence of harmonic noise or a surge voltage that is a factor of burning.

For this reason, the applied voltage can be used to monitor or predict insulation deterioration.

### (Correlation between a current value and an insulation state)

Since a motor current is supplied from the motor control device 26 to the winding wire 31 of the motor section 20 when the motor is driven at predetermined rotation speed, the motor current changes according to an insulation state of the winding wire 31.

For example, when insulation of the winding wire 31 is excessively deteriorated, a winding wire resistance value increases and heat generation of the motor increases. That is, when insulation resistance increases due to insulation deterioration of the winding wire, a phenomenon such as layer short in which the winding wire is overheated and thermally damaged occurs.

When there is unbalance in voltage values among phases of a three-phase power supply, a phenomenon in which a lot of an electric current flows concentratedly to only one phase occurs and a phenomenon in which only the one phase is burned and the winding wire is discolored black occurs. It has been confirmed that, in a relation between a voltage imbalance rate and phase currents, although there is a difference depending on the number of poles and output, the phase currents are greatly different when a slight voltage imbalance rate occurs.

For this reason, a motor current value can be used in order to monitor or predict insulation deterioration together with burning of a coil.

### (Correlation between data of the temperature of the winding wire or temperature, a temperature difference, or pressure correlated with the temperature of the winding wire and an insulation state)

Insulation deterioration of the winding wire is mainly due to thermal deterioration. That is, when the winding wire has heat, deterioration, breakage, and burning of an insulator occur. Overheat of the winding wire burns and discolors the entire winding wire.

Since heat generation of the motor 24 occurs mainly in the winding wire 31, it is considered most preferable to directly monitor the winding wire in monitoring an insulation state of the winding wire. Moreover, since the coil end housing section, which is a sealed space, is a portion in which heat generated from coil ends is easily retained and less easily radiated, the coil ends have the highest temperature in the winding wire. Therefore, the temperature of the winding wire, in particular, the temperature of the coil ends (T1: the temperature of the coil end on the far side from the pump or T2: the temperature of the coil end disposed on the pump side) or the temperature (T3) of the winding wire 31 wound on the teeth in the stator core 30 can be used in order to monitor or predict an insulation state of the winding wire.

Since the winding wire 31 is fixed to the stator core 30, the winding wire and the stator directly receive thermal influence from each other. Since heat generated by the winding wire 31 is transferred to the backup sleeves 34a and 34b, the end bells 42 and 43, the bearing holders 44 and 46, and the like as radiant heat, surface temperatures thereof fluctuate according to the temperature of the winding wire 31. Note that, in the present embodiment in which the internal circulation liquid is present (as illustrated in FIG. 2, when a flow of the internal circulation liquid indicated by the arrow is present in the can 33), the surface temperatures also change according to a state (an amount and temperature) of the internal circulation liquid.

Therefore, the temperatures (T4 and T5: the temperature of the backup sleeves 34a and 34b, T6 and T7: the temperature of the end bells 42 and 43, and T8 and T9: the temperature of the bearing holders 44 and 46) can also be used to monitor or predict the insulation state of the winding wire.

Further, the pressure: P1 in the stator chamber 45 (the coil end housing sections 45a and 45b) rises according to the rise of the temperature of the winding wire 31. Moreover, when the winding wire 31 is burned, organic materials are gasified and the pressure in the stator chamber 45 (the coil end housing sections 45a and 45b) easily rises. For this reason, if correlation accuracy between the temperature of the winding wire 31 and the pressure in the stator chamber 45 is within an allowable range, the pressure in the stator chamber 45 can also be used to monitor or predict the insulation state of the winding wire.

Note that, by also measuring the pressure: P2 in the rotor chamber 50 and monitoring the difference (ΔP) between the pressure: P2 and the pressure: P1 in the stator chamber 45, it is possible to detect breakage (P1=P2) of the can 33 and also detect a failure of the motor.

As described above, in order to monitor or predict the insulation state of the winding wire, any one of the winding wire temperature or the temperature (for example, the temperature of the stator core, the temperature of the stator chamber, the surface temperature of the backup sleeves 34a and 34b, and the surface temperature of the end bells 42 and 43) correlated with the winding wire temperature, the temperature difference (for example, the temperature difference of the winding wire in the phases, the difference (Δt) between the temperature of the phases of the winding wire and the temperature of the handling liquid, or a difference (T5-T4) between the temperatures T4 and T5 of the front and rear backup sleeves 34a and 34b), or the pressure (for example, the pressure in the stator chamber 45) correlated with the winding wire temperature may be used. However, a plurality of these may be used according to necessity. In the present embodiment, a case in which any one of the above is used is described.

### (Correlation between data of an inflow temperature and a flow rate of the handling liquid and an insulation state)

In the canned motor pump 2, since the can 33 is in contact with the inner circumferential surface of the stator core 30, the temperature of the stator 23 is predominantly affected by the temperature of the handling liquid. That is, since heat transfer occurs between the stator 23 and the handling liquid via the can 33 having small thickness and high thermal conductivity, the temperature of the stator 23 is greatly affected by an inflow temperature and a flow rate of the handling liquid. For example, when the temperature of the handling liquid rises, the temperature of the stator core 30 also rises and the winding wire 31 has higher temperature than the temperature of the handling liquid because the winding wire 31 generates heat by itself. For this reason, in the canned motor pump 2 that often handles high-temperature handling liquid, the winding wire 31 is easily exposed to high-temperature atmosphere in which insulation deterioration easily occurs.

As described above, the flow rate and the temperature of the handling liquid are bases in evaluating the insulation state of the winding wire. Therefore, the flow rate and the temperature of the handling liquid are important in monitoring or predicting the insulation state.

About the data of the motor voltage value and current value, the data of the temperature of the winding wire 31 of the motor section 20 or the temperature, the temperature difference, or the pressure correlated with the temperature of the winding wire 31, and the data of the inflow temperature and the flow rate of the handling liquid, the influence on the insulation state is as described above. However, the insulation state of the winding wire complicatedly changes with these data comprehensively affecting one another. For this reason, it is difficult to appropriately determine the insulation state simply by individually determining the data described above. In order to appropriately determine the insulation state of the winding wire that complicatedly changes, it is necessary to comprehensively take into account the data described above.

As illustrated in FIG. 2, even in the canned motor pump 2 not including a cooling device in the motor section 20, heat generated by the winding wire 31 of the motor section 20 is emitted to the atmosphere via the motor housing 25 (the outer cylinder 41, the end bells 42 and 43 at both the ends, and the bearing holder 44) and, if the temperature of the heat is higher than the temperature of the handling liquid, the heat is emitted to the handling liquid as well via the can 33.

However, when there is no great change in operation conditions for the canned motor pump 2 used in a plant and heat radiation conditions are also stable, it is possible to simply grasp a heat balance of the canned motor pump. If data collected at predetermined timing under predetermined conditions (data of a voltage value and a current value supplied to the motor section 20, data of the temperature of the winding wire of the stator or temperature, a temperature difference, or pressure correlated with the temperature of the winding wire, and data of an inflow temperature and a flow rate of the handling liquid) is used as input data of learning data, it is possible to grasp a tendency of the insulation state of the winding wire 31.

In contrast, when it is considered that the data of the voltage value and the current value supplied to the motor section 20, the data of the temperature of the winding wire 31 of the stator 23 or the temperature, the temperature difference, or the pressure correlated with the temperature of the winding wire 31, and the data of the inflow temperature and the flow rate of the handling liquid frequently fluctuates, a heat radiation amount into the atmosphere fluctuates considerably due to variations in atmospheric temperature and the insulation state of the winding wire 31 is complicatedly affected, correlation accuracy is inferior in grasping pinpoint input data (input data at predetermined timing). Therefore, in such a case, data over time in a predetermined period is desirably used as the input data of the learning data.

That is, data of a voltage value and a current value supplied to the motor section in the predetermined time, data of the temperature of the winding wire of the stator or temperature, a temperature difference, or pressure correlated with the temperature of the winding wire in the predetermined period, and data of an inflow temperature and a flow rate of the handling liquid in the predetermined period may be used as input data. In the case of the "supervised learning", an insulation state over time of the winding wire in the predetermined period is desirably used for output data (teacher data) associated with the input data.

Here, the input data and the output data in the predetermined period are constituted by a plurality of measurement values measured by the sensors at a plurality of measurement time points in the predetermined period. For example, pieces of measurement data are measured at a predetermined sampling cycle in the predetermined period and constituted as array data arranged in time-series order in correlation with measurement time.

### (Machine learning method)

When performing the "supervised learning" as the machine learning, the machine learning device 4 forms a learning model using, for example, a neural network model. The neural network model itself is a publicly-known model. Input data included in learning data is input to an input layer and output data output from an output layer as a result of an inference of the input data and output data (teacher data) included in the learning data are compared to learn a correlation between the input data and the output data.

As advance preparation for causing the machine learning device 4 to perform the machine learning, the learning data acquirer 121 acquires a desired number of pieces of learning data and stores an acquired plurality of sets of learning data in the learning data storage 123. The number of pieces of learning data prepared here is set as appropriate considering inference accuracy required of the learning model 6.

Various methods can be adopted for the acquisition of the learning data. For example, when an abnormality has occurred in the insulation state of the winding wire 31 or when a sign of an abnormality has been recognized, measurement values at that time point or in a predetermined period before and after the time point are acquired from the sensors by the measurement device 3. In association with the acquired measurement values, a diagnosis result (here, since the abnormality has occurred or the sign of the abnormality has been recognized, the output data is "1") is input from the operation interface 112, one set of learning data (input data and output data) is prepared in this way, and this is repeated to prepare a plurality of sets of learning data.

Insulation deterioration occurs for a long time in some cases and occurs all at once in other cases. Therefore, when it is hard to grasp occurrence of an abnormality or a sign of an abnormality, an abnormal state of insulation may be intentionally caused to acquire the learning data. A plurality of sets of input data and output data at the time of a normal state in which an abnormality has not occurred in the insulation state are also prepared for the learning data.

In order to start the machine learning, the learning model 6 before learning constituted by the neural network model is prepared. Each of data of a motor voltage value and current value, data of the temperature of the winding wire 31 of the stator or temperature, a temperature difference, or pressure correlated with the temperature of the winding wire 31, and data of the inflow temperature and a flow rate of the handling liquid serving as the input data included in the learning data is associated with the input layer of the learning model 6 and diagnosis information (an insulation state) serving as the output data included in the learning data is associated with the output layer of the learning model 6.

Through the advance preparation described above, the machine learner 122 performs, for example, a series of processing of a flowchart illustrated in FIG. 4 and generates a learned model.

In step S100, the machine learner 122 acquires one set of learning data from the plurality of sets of learning data stored in the learning data storage 123. The learning data may be acquired in predetermined order or may be acquired at random.

Subsequently, in step S110, the machine learner 122 carries out supervised machine learning. That is, the machine learner 122 inputs input data included in the acquired one set of learning data to a prepared learning model and causes the learning model to output an inference result, compares the inference result with output data (teacher data) included in the learning data acquired in step S100, and carries out the machine learning with a publicly-known neural network method. Accordingly, the machine learner 122 causes the learning model 6 to learn a correlation between the input data and the output data (diagnosis information of an insulation state of the winding wire).

Thereafter, the machine learner 122 performs the work described above on the prepared remaining learning data using the learning model being learned and continues the learning in the machine learner 122. At this time, the machine learner 122 determines presence or absence of the continuation of the machine learning based on an error between the output data and the teacher data, the number of times of learning, the remaining number of pieces of unlearned learning data stored in the learning data storage 123, and the like (step S120).

That is, when determining in step S120 to continue the machine learning (YES), the machine learner 122 carries out the process of steps S100 to S110 on the learning model 6 being learned using the unlearned learning data. In contrast, when determining in step S120 not to continue the machine learning (NO), in step S130, the machine learner 122 stores the generated learned learning model 6 in the learned model storage 124 and ends the machine learning.

### (Action effects of the machine learning device and the machine learning method according to the first embodiment)

With the machine learning device 4 and the machine learning method according to the first embodiment described above, it is possible to provide the learning model 6 capable of accurately inferring (diagnosing) diagnosis information of an insulation state of the winding wire 31 from data of a voltage value and a current value supplied to the motor section 20, data of the temperature of the winding wire 31 of the stator 23 or temperature, a temperature difference, or pressure correlated with the temperature of the winding wire 31, and data of an inflow temperature and a flow rate of the handling liquid.

### (Insulation state diagnosis device)

Next, the insulation state diagnosis device 5 that infers (diagnoses) an insulation state of the winding wire 31 using the learned learning model 6 generated using the method described above is described.

The insulation state diagnosis device 5 is configured with a general-purpose or dedicated computer. The computer may be either a stationary computer or a portable computer, may be a client computer, or may be a server computer or a cloud computer.

The insulation state diagnosis device 5 may be incorporated in the motor control device 26 or may be incorporated in a host management device of the motor control device 26.

Further, the computer configuring the insulation state diagnosis device 5 may be the same as or may be different from the computer configuring the machine learning device 4 described above.

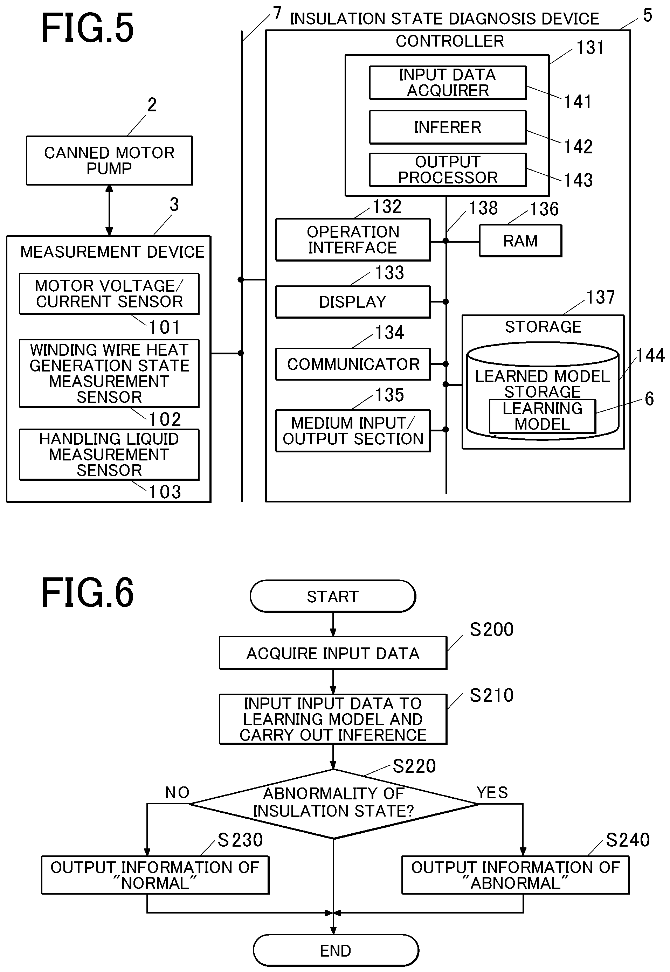

The insulation state diagnosis device 5 includes, as illustrated in FIG. 5, a controller 131, an operation interface 132, a display 133, a communicator 134, a medium input/output section 135, a RAM 136, a storage 137, and a bus 138. The sections of the insulation state diagnosis device 5 are connected via the bus 138.

The controller 131 is configured with an arithmetic processing device (a processor such as a CPU, an MPU, or a DSP) and reads and executes a program loaded in the RAM 136 and performs various kinds of arithmetic processing to control operations of the sections of the insulation state diagnosis device 5.

Note that the controller 131 may include a plurality of processors and the plurality of processors may execute various kinds of processing in the present embodiment. In this case, the plurality of processors may be involved in common processing and the plurality of processors may independently execute different kinds of processing in parallel.

The operation interface 132 is configured with, for example, a keyboard, a mouse, a tenkey pad, or an electronic pen and functions as an input section.

The display 133 is configured with, for example, a liquid crystal display, an organic EL display, an electronic paper, or a projector and functions as an output section.

The operation interface 132 and the display 133 may be integrally configured like a touch panel display.

The communicator 134 is connected to the measurement device 3 via the network 7 and functions as a communication interface that transmits and receives various data (measurement data and the like).

The medium input/output section 135 is configured with, for example, a DVD drive, a CD drive, or a USB port and reads data from and writes data in a medium (a non-transitory storage medium) such as a DVD, a CD, or a USB.

The RAM 136 is configured with a volatile memory (a DRAM, an SRAM, or the like) that stores various data and programs and functions as a main memory.

The storage 137 is configured with a storage device such as a HDD or an SSD and stores various data necessary for execution of an operating system or programs.

Note that the programs may be stored in the storage 137 instead of the RAM 136. The programs may be recorded in a medium in an installable file format or an executable file format and provided to the insulation state diagnosis device 5 via the medium input/output section 135. The programs may be provided to the insulation state diagnosis device 5 by being downloaded through the network 7 via the communicator 134.

The controller 131 executes an insulation state diagnosis program (not illustrated) to function as an input data acquirer 141, an inferer 142, and an output processor 143.

The storage 137 includes a learned model storage 144 functioning as a database that stores the learned learning model 6 subjected to machine learning.

The input data acquirer 141 is an interface unit that is connected to, via the communicator 134 and the network 7, the measurement device 3 (the motor voltage/current sensor 101, the winding wire heat generation state measurement sensor 102, and the handling liquid measurement sensor 103) provided in the canned motor pump 2 serving as an actual machine and acquires input data based on measurement values measured by the measurement device 3 (data of a motor voltage value and current value, data of the temperature of the winding wire of the stator or temperature, a temperature difference, or pressure correlated with the temperature of the winding wire, and data of an inflow temperature and a flow rate of the handling liquid at predetermined timing or data of a motor voltage value and current value, data of temperature of the winding wire of the stator or temperature, a temperature difference, or pressure correlated with the temperature of the winding wire, and data of an inflow temperature and a flow rate of the handling liquid in a predetermined period).

Note that, here as well, an example is described in which, as the input data, raw data (unprocessed data) of the data of the voltage value and the current value supplied to the motor section 20 (the motor 24), the data of the temperature of the winding wire 31 of the stator 23 or the temperature, the temperature difference, or the pressure correlated with the temperature of the winding wire 31, and the data of the inflow temperature and the flow rate of the handling liquid are used. However, data obtained by applying preprocessing to at least a part of the data of the voltage value and the current value supplied to the motor section 20 (the motor 24), the data of the temperature of the winding wire 31 of the stator 23 or the temperature, the temperature difference, or the pressure correlated with the temperature of the winding wire 31, and the data of the inflow temperature and the flow rate of the handling liquid may be used as the input data matching learning data.

The inferer 142 inputs the input data acquired by the input data acquirer 141 to the learning model 6 and performs inference processing of inferring diagnosis information of the insulation state of the winding wire 31. The learned learning model 6 on which the supervised learning has been carried out generated by the machine learning device 4 is used for the inference processing.

The inferer 142 may not only include a function of performing the inference processing using the learning model 6 but also include, as preprocessing of the inference processing, a preprocessing function of adjusting the input data acquired by the input data acquirer 141 to a desired format or the like and inputting the input data to the learning model 6 and include, as post-processing of the inference processing, a post-processing function of applying a predetermined logical formula or calculation formula to a value of the output data output from the learning model 6 to finally diagnose the insulation state of the winding wire 31.

The learned model storage 144 is a database that stores the learned learning model 6 used for the inference processing of the inferer 142. Note that the number of learning models 6 stored in the learned model storage 144 is not limited to one. For example, a plurality of learning models 6 in a case in which input data is different, a case in which the number of pieces of input data is different, or a case in which a method of machine learning is different may be stored and selected and used as appropriate.

As an example of the case in which the input data is different, a case in which, instead of the temperature of the winding wire of the stator, temperature, a temperature difference, or pressure correlated with the temperature of the winding wire is used for a learning model using data of a motor voltage value and current value and data of the temperature of the winding wire of the stator and data of an inflow temperature and a flow rate of the handling liquid is equivalent. As the case in which the number of pieces of input data is different, for example, a case in which data affecting a heat radiation amount is further added to a model of a heat balance of the motor section is equivalent (this is described below).

The output processor 143 performs output processing of outputting the inference result of the inferer 142, that is, the diagnosis information of the insulation state of the winding wire 31. Various means can be adopted as specific output means. For example, the output processor 143 may notify the diagnosis information to an operator by display, mail, or the like and transmit the diagnosis information to the motor control device 26 and the host management device thereof and stores the diagnosis information as a diagnosis history of the canned motor pump 2 to use the diagnosis information for driving control for the motor section 20 and the pump section 10.

### (Insulation state diagnosis method)

An example of an insulation state diagnosis method using the insulation state diagnosis device 5 is illustrated as a flowchart in FIG. 6. In this example, a case is described in which diagnosis information of an insulation state being normal is defined as a state of "0" and the diagnosis information being abnormal is defined as a state of "1".

First, in step S200, the input data acquirer 141 acquires input data based on measurement values (data of a motor voltage value and current value, data of the temperature of the winding wire of the stator or temperature, a temperature difference, or pressure correlated with the temperature of the winding wire, and data of an inflow temperature and a flow rate of the handling liquid at predetermined timing or data of a motor voltage value and current value, data of the temperature of the winding wire of the stator and temperature, a temperature difference, or pressure correlated with the temperature of the winding wire, and data of an inflow temperature and a flow rate of the handling liquid in a predetermined period) measured by the measurement device 3 (the motor voltage/current sensor 101, the winding wire heat generation state measurement sensor 102, and the handling liquid measurement sensor 103).

Subsequently, in step S210, the inferer 142 inputs the input data to the input layer of the learned learning model 6 and carries out inference.

Thereafter, in step 220, the inferer 142 determines presence or absence of an abnormality of the insulation state based on an inference result. That is, as an example of post-processing of the supervised learning, the inferer 142 compares a value (a number between 0 and 1) of the output data and a predetermined threshold and discriminates whether the insulation state is normal or abnormal. For example, if the value of the output data is smaller than the predetermined threshold, the inferer 142 determines that the insulation state is "not abnormal" (NO) and, if the value of the output data is equal to or larger than the predetermined threshold, the inferer 142 determines that the insulation state is "abnormal" (YES).

Subsequently, when the inference result of the inferer 152 in step 220 (a diagnosis result of the insulation state of the winding wire) indicates not abnormal (NO), the output processor 154 outputs information representing "normal" in step S230 and, when the inference result indicates abnormal (YES), the output processor 154 outputs information representing "abnormal" in step 240 (step S240).

After the diagnosis information in step S230 or S240 is output, the diagnosis processing for the insulation state of the winding wire is ended.

### (Action effects of the insulation state diagnosis device and the insulation state diagnosis method according to the first embodiment)

With the insulation state diagnosis device 5 and the insulation state diagnosis method according to the first embodiment described above, it is possible to highly accurately diagnose the insulation state of the winding wire 31 without relying on the experience and intuition of the operator and without stopping the canned motor pump 2.

That is, in order to appropriately determine an insulation state under conditions that complicatedly change, since the insulation state cannot be appropriately determined even if individual pieces of input data are separately monitored, in the related art, the canned motor pump is stopped to measure insulation resistance and inter-terminal resistance and perform tendency management. This greatly relies on the experience and intuition of the operator. However, with this diagnosis device, by using a learning model generated using, as input data, data of a voltage value and a current value supplied to the motor section, data of the temperature of the winding wire or temperature, a temperature difference, or pressure correlated with the temperature of the winding wire, and data of an inflow temperature and a flow rate of the handling liquid, even when the insulation state of the winding wire receives various influences and changes, it is possible to accurately diagnose the insulation state of the winding wire without relying on the experience and intuition of an expert.

In the example described above, when a heat balance affecting the insulation state of the winding wire of the canned motor pump is considered, a change in a heat radiation amount is not actively taken into account. However, in a case in which the motor section 20 includes a cooling device, the change in the heat radiation amount cannot be neglected.

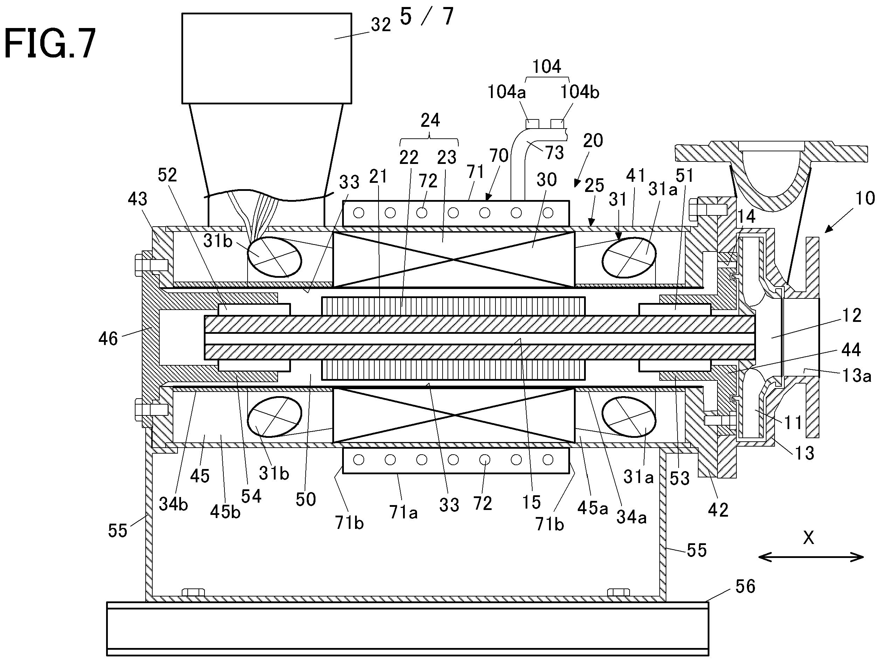

In FIG. 7, an example of a canned motor pump including a cooling device 70 in the motor section 20 is illustrated. In this example, a cooling jacket 71 is disposed around the motor section 20, that is, on the outer side of the outer cylinder 41. The cooling jacket 71 is formed by the outer cylinder 41, a jacket outer peripheral section 71a disposed further on the outer side than the outer cylinder 41, and two end portion plates 71b disposed at both ends of the jacket outer peripheral section 71a. A cooling pipe 72 is disposed on the inside of the cooling jacket 71. A space other than the cooling pipe is filled with a heat transfer medium. Here, as the heat transfer medium, for example, oil, silica, or aluminum powder is used.

Cooling liquid supplied to the cooling pipe 72 in the cooling jacket 71 may be supplied by selecting, as appropriate, cooling liquid in a system different from a system of the handling liquid of the pump section 10 or the handling liquid flowing in the pump section 10 may be supplied. When the handling liquid flowing in the pump section 10 is supplied, the handling liquid is sent to the rotor chamber 50 after passing through the cooling pipe 72.

Note that, since the other components of the canned motor pump 2 are the same as the components illustrated in FIG. 2, the same parts are denoted by the same reference numerals and signs and description of the parts is omitted.

When the cooling device 70 described above is provided, a condition serving as a reference for the winding wire 31 to be exposed changes depending on the temperature and a flow rate of the cooling liquid as well. Thus, when the cooling device 70 described above is provided, a cooling liquid measurement sensor 104 that measures an inflow temperature and a flow rate of the cooling liquid is provided in a conduit 73 for supplying the cooling liquid to the cooling jacket 71.

The cooling liquid measurement sensor 104 is configured with, for example, an inflow temperature sensor 104a and a flow rate sensor 104b provided in the conduit for supplying the cooling liquid to the cooling jacket 71. As the inflow temperature sensor 104a and the flow rate sensor 104b, sensors of the same type as the inflow temperature sensor 103a and the flow rate sensor 103b of the handling liquid measurement sensor 103 only need to be used.

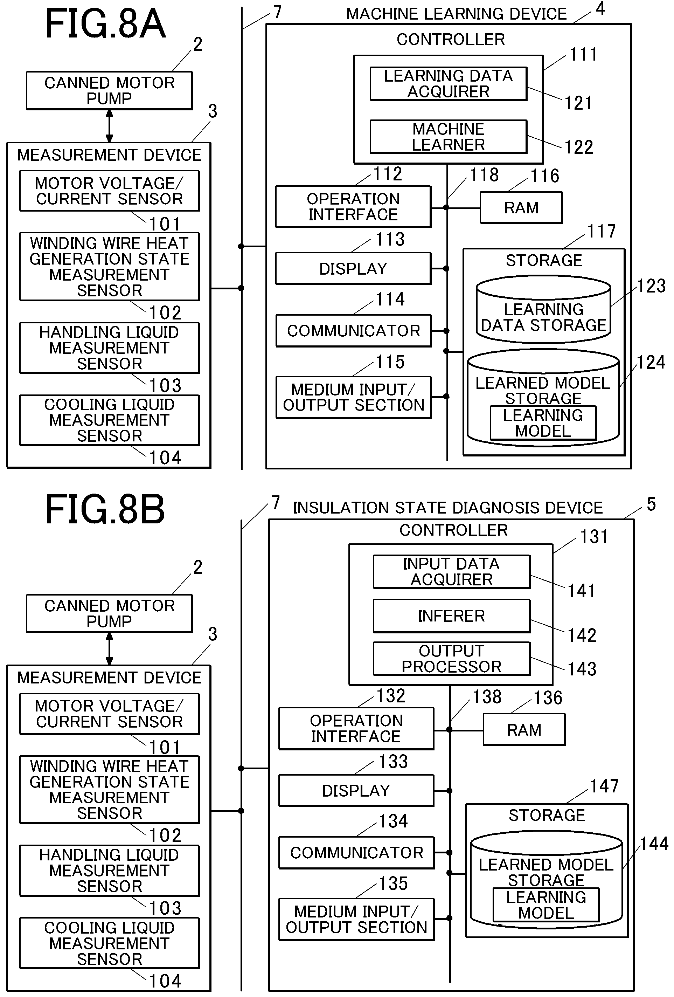

As data measured by the measurement device 3 used in the machine learning device 4 and the insulation state diagnosis device 5, as illustrated in FIG. 8A and FIG. 8B, an inflow temperature and a flow rate of the cooling liquid measured by the cooling liquid measurement sensor 104 are desirably added. That is, the inflow temperature and the flow rate of the cooling liquid are desirably included in the input data included in the learning data in the learning phase and the inflow temperature and the flow rate of the cooling liquid are desirably included in the input data for diagnosis in the inference phase.

Note that, in this case as well, the inflow temperature and the flow rate of the cooling liquid used as the input data are not limited to raw data (unprocessed data) obtained by the inflow temperature sensor 103a and the flow rate sensor 103b. Preprocessed data may be used.

As data of the temperature and the flow rate of the cooling liquid, data at predetermined timing may be used or data in a predetermined period may be used in order to improve correlation accuracy and inference accuracy.

Therefore, when the cooling device 70 is provided in the motor section 20, by further taking into account the inflow temperature and the flow rate of the cooling liquid in the learning phase and the inference phase, it is possible to more accurately infer (diagnose) the insulation state of the winding wire 31.

### (Second Embodiment)

In the first embodiment described above, the case in which the "supervised learning" is adopted as the machine learning is described. In the present embodiment, a case in which "unsupervised learning" is adopted is described. Note that, since basic configurations and operations of the measurement device 3, the machine learning device 4, and the insulation state diagnosis device 5 configuring the insulation state diagnosis system 1 for the canned motor pump 2 and the winding wire 31 according to the second embodiment are the same as those in the first embodiment, description of the configurations and the operations is omitted. Differences from the first embodiment are mainly described below.

As in the first embodiment, the machine learning device 4 includes, as illustrated in FIG. 3, the learning data acquirer 121, the learning data storage 123, the machine learner 122, and the learned model storage 124.

When the "unsupervised learning" is adopted as the machine learning, as learning data, only input data at the time when diagnosis information indicates that an insulation state of the winding wire at predetermined timing or an insulation state of the winding wire in a predetermined period is a predetermined state is used. That is, the learning data is constituted not to include output data (teacher data).

When presence or absence of an abnormality is diagnosed as the insulation state of the winding wire 31, the diagnosis information is constituted as information indicating whether the insulation state is normal or abnormal. Here, the diagnosis information is constituted by only input data (data of a voltage value and a current value supplied to the motor section, data of the temperature of the winding wire of the stator and temperature, a temperature difference, or pressure correlated with the temperature of the winding wire, and data of an inflow temperature and a flow rate of the handling liquid and, when the cooling device is present, an inflow temperature and a flow rate of the cooling liquid) at the time when the insulation state of the winding wire is normal.

When acquiring the learning data described above, the learning data acquirer 121 acquires, as the input data, data of a voltage value and a current value supplied to the motor section, data of the temperature of the winding wire of the stator and temperature, a temperature difference, or pressure correlated with the temperature of the winding wire, and data of an inflow temperature and a flow rate of the handling liquid and, when the cooling device is present, an inflow temperature and a flow rate of the cooling liquid at predetermined timing or in a predetermined period measured by the measurement device 3 provided in the canned motor pump 2 serving as the test machine. At the same time, an operator diagnoses an insulation state at the timing or in the predetermined period when the input data is measured and inputs, from the operation interface 112, a result of the diagnosis being normal to form a set of learning data and stores the set of learning data in the learning data storage 123. By repeating the work described above, the operator stores a plurality of sets of learning data in the learning data storage 123.

In this case as well, even if the learning data acquirer 121 collects the input data included in the learning data by attaching the sensors (the motor voltage/current sensor 101, the winding wire heat generation state measurement sensor 102, and the handling liquid measurement sensor 103) serving as the measurement device 3 to the sections of the canned motor pump 2 serving as the test machine and connecting the measurement device 3 to the machine learning device 4 via the network 7, if the collected learning data (the data of the motor voltage/current value, the data of the temperature of the winding wire or the temperature, the temperature difference, or the pressure correlated with the temperature of the winding wire, and the data of the inflow temperature and the flow rate of the handling liquid serving as the input data) is already present, the learning data acquirer 121 may load the existing learning data to the learning data storage 123 via the medium input/output section 115 and the communicator 114 and the network 7.

In this embodiment as well, the input data is not limited to raw data (unprocessed data). Data obtained by applying the same preprocessing as the preprocessing described above to at least a part of the data may be used.

By inputting the learning data to the learning model, the machine learner 122 causes the learning model to learn a correlation between the input data included in the learning data and the diagnosis information indicating that the insulation state of the winding wire is normal and generates a learned model. As a method of the unsupervised learning by the machine learner, for example, an auto encoder model is desirably adopted.

The autoencoder model itself is a publicly-known model. The input data included in the learning data is input to an input layer and the input data and output data output from an output layer as an inference result are compared to learn a pattern and a tendency of the input data. A series of processes described above is repeatedly carried out on a learning model being learned and, when a predetermined learning end condition is satisfied, the machine learning is ended and a learned autoencoder model is generated.

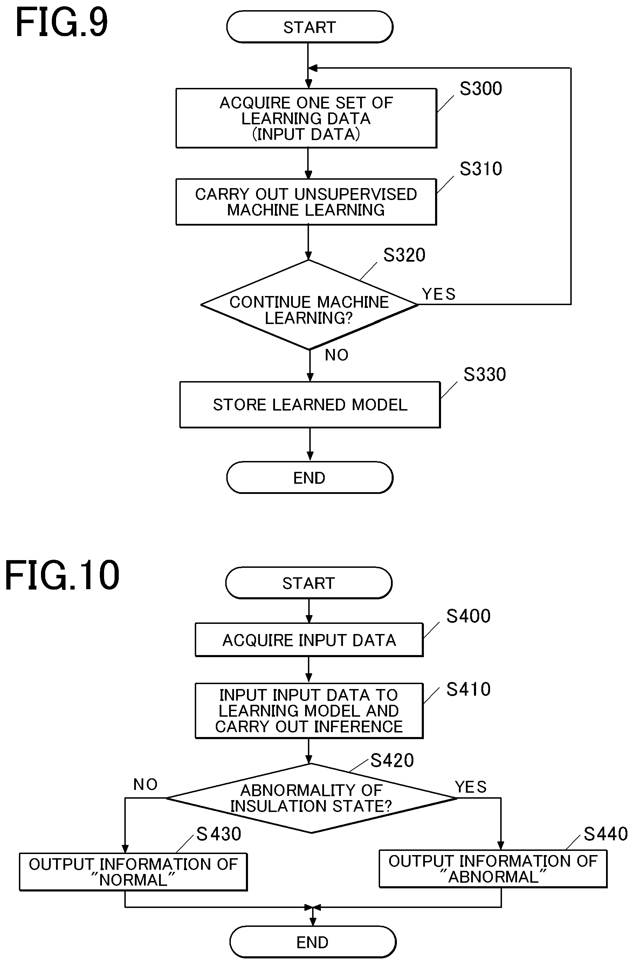

In FIG. 9, an example of a machine learning method using the machine learning device according to the second embodiment is illustrated as a flowchart.

In this example as well, as advance preparation for causing the machine learning device 4 to perform the machine learning, the learning data acquirer 121 acquires a desired number of pieces of learning data and stores an acquired plurality of sets of learning data in the learning data storage 123. The number of pieces of learning data prepared here is set as appropriate considering inference accuracy required of the learning model 6.

Various methods can be adopted for the acquisition of the learning data. For example, the input data constituting the learning data is prepared by acquiring, using the measurement device 3, various measurement values at predetermined timing or in a predetermined period in the case in which the insulation state of the winding wire 31 in the canned motor pump 2 serving as the test machine is a normal state. A plurality of sets of learning data are prepared by repeating the work described above.

In order to start the machine learning, the learning model 6 before learning constituted by an autoencoder model is prepared. The data of the voltage value and the current value supplied to the motor section, the data of the temperature of the winding wire of the stator or the temperature, the temperature difference, or the pressure correlated with the temperature of the winding wire, and the data of the inflow temperature and the flow rate of the handling liquid serving as the input data included in the learning data are associated with the input layer of the learning model 6 and, when the cooling device is present, the data of the inflow temperature and the flow rate of the cooling liquid is further correlated with the input data.

After the advance preparation ends, first, in step S300, the machine learner 122 acquires one set of learning data from the plurality of sets of learning data stored in the learning data storage 123. The learning data may be acquired in predetermined order or may be acquired at random.

Subsequently, in step S310, the machine learner 122 carries out unsupervised machine learning. That is, the machine learner 122 inputs the input data included in the acquired one set of learning data to the prepared learning model and causes the learning model to output an inference result, compares the input data included in the learning data and output data serving as an inference result output from the output layer, and carries out the machine learning with a publicly-known autoencoder method.

Thereafter, the machine learner 122 performs the work described above on the prepared remaining learning data using the learning model being learned and continues the learning in the machine learner 122. At this time, the machine learner 122 determines presence or absence of the continuation of the machine learning based on the number of times of learning, the remaining number of pieces of unlearned learning data stored in the learning data storage 123, and the like (step S320).

That is, when determining in step S320 to continue the machine learning (YES), the machine learner 122 carries out the process of steps S300 to S310 on the learning model 6 being learned using the unlearned learning data. In contrast, when determining in step S320 not to continue the machine learning in the machine learner 122 (NO), in step S330, the machine learner 122 stores the generated learned learning model 6 in the learned model storage 124 and ends the machine learning.

### (Action effects of the machine learning device and the machine learning method according to the second embodiment)

If the machine learning device and the machine learning method according to the second embodiment described above are used, it is possible to provide the learning model 6 capable of highly accurately inferring (estimating) diagnosis information of the insulation state of the winding wire from the data of the motor voltage value and current value, the data of the temperature of the winding wire of the stator and the temperature, the temperature difference, or the pressure correlated with the temperature of the winding wire, and the data of the inflow temperature and the flow rate of the handling liquid at the predetermined timing or the data of the motor voltage value and current value, the data of the temperature of the winding wire of the stator and the temperature, the temperature difference, or the pressure correlated with the temperature of the winding wire, and the data of the inflow temperature and the flow rate of the handling liquid in the predetermined period.

The insulation state diagnosis device 5 in this embodiment has the same configuration as the configuration in the first embodiment in FIG. 5. That is, the insulation state diagnosis device 5 includes the input data acquirer 141, the inferer 142, the output processor 143, and the learned model storage 144.

As in the first embodiment, the inferer 152 inputs the input data acquired by the input data acquirer 141 to the learned learning model 6 and performs inference processing of inferring diagnosis information of the insulation state of the winding wire. However, for the inference processing, a learned model on which the unsupervised learning is carried out in the machine learning device 4 is used.

FIG. 10 is a flowchart illustrating an example of an insulation state diagnosis method for the winding wire 31 by the insulation state diagnosis device 5 according to the second embodiment. In this example, a case is described in which diagnosis information of an insulation state being normal is defined as a state of "0" and the diagnosis information being abnormal is defined as a state of "1".

First, in step S400, the input data acquirer 141 acquires input data based on measurement values (data of a motor voltage value and current value, data of the temperature of the winding wire of the stator or temperature, a temperature difference, or pressure correlated with the temperature of the winding wire, and data of an inflow temperature and a flow rate of the handling liquid and, when the cooling device is present, data of an inflow temperature and a flow rate of the cooling liquid at predetermined timing or in a predetermined period) measured by the measurement device 3 (the motor voltage/current sensor 101, the winding wire heat generation state measurement sensor 102, and the handling liquid measurement sensor 103 and, when the cooling device 70 is present, the cooling liquid measurement sensor 104).

Here, as the input data, a part of data subjected to preprocessing may be used.

Subsequently, in step S410, the inferer 142 inputs the input data to the input layer of the learning model 6 and carries out inference and acquires output data output from the output layer of the learning model 6.

Thereafter, in step S420, the inferer 142 determines presence or absence of an abnormality of the insulation state based on an inference result. That is, as an example of post-processing of the unsupervised learning, the inferer 142 calculates a difference between a feature value based on the input data and a feature value based on the output data and, if the difference is smaller than a predetermined threshold, determines that the insulation state is "not abnormal" (NO) and, if the difference is equal to or larger than the predetermined threshold, the inferer 142 determines that the insulation state is "abnormal" (YES).

Subsequently, in step S430, when diagnosis information of the insulation state of the winding wire, which is an inference result of the inferer 152, is determined as not abnormal (NO), the output processor 154 outputs information representing "normal" (step S430) and, when the diagnosis information is determined as "abnormal" (YES), the output processor 154 outputs information representing "abnormal" (step S440).

After the diagnosis information in step S430 or S440 is output, the diagnosis processing for the insulation state of the winding wire is ended.

### (Action effects of the insulation state diagnosis device and the insulation state diagnosis method according to the second embodiment)

In the insulation state diagnosis device 5 and the insulation state diagnosis method according to the second embodiment described above as well, it is possible to highly accurately diagnose the insulation state of the winding wire without relying on the experience and intuition of the operator and without stopping the canned motor pump 2.

### (Other embodiments)

Note that, in the embodiments described above, as the specific method of the machine learning by the machine learner 122, the case in which the neural network (the first embodiment) and the autoencoder (the second embodiment) are respectively adopted is described. However, the machine learner 122 may adopt any other method of the machine learning. For example, a tree model such as a decision tree or a regression tree, ensemble learning such as bagging or boosting, a neural network model (including deep learning) such as a recurrent neural network or a convolutional neural network, a clustering model such as hierarchical clustering, non-hierarchical clustering, a k-nearest-neighbor method, or a k-means method, a multivariate analysis such as a principal component analysis, a factor analysis, or logistic regression, or a support vector machine may be adopted.

The machine learning device 4 and the insulation state diagnosis device 5 described above can also be provided in a form of a program (a machine learning program and an insulation state diagnosis program) for causing the machine learning device 4 and the insulation state diagnosis device 5 to execute the steps included in the machine learning method and the insulation state diagnosis method described above.

In the example described above, as the data of the temperature of the winding wire 31 of the stator 23 or the temperature, the temperature difference, or the pressure correlated with the temperature of the winding wire 31, the measurement data at the predetermined timing of the respective sensors or the measurement data in the predetermined time is used as the input data of the learning data. However, as the input data, data of a temperature difference correlated with the temperature of the winding wire 31 may be adopted as appropriate. For example, even when the voltage value and the current value supplied to the motor section 20 are constant, if winding wire resistance values of the phases become unbalance according to insulation deterioration, variation occurs in the temperatures of the winding wire in the phases. Therefore, data of temperature differences of the winding wire in the phases may be used.

Further, when the difference (Δt) between the temperatures in the phases of the winding wire and the temperature of the handling liquid or the difference (T5-T4) between the temperatures T4 and T5 of the front and rear backup sleeves 34a and 34b is monitored as the data of the temperature difference correlated with the temperature of the winding wire 31, abnormal heat generation of the motor (the winding wire 31) can also be detected. Therefore, data of these temperature differences may be used as the input data.

### (Implementation modes of the present invention)

Next, implementation modes of the present invention grasped from the embodiments described above are described below while using the terms and the reference numerals and signs described in the embodiments.

A first implementation mode of the present invention is a machine learning device (for example, the machine learning device 4), wherein a canned motor pump (for example, the canned motor pump 2) includes, a motor section (for example, a motor section 20) and a pump section (for example, the pump section 10) driven by the motor section,
the motor section including, a rotor (for example, the rotor 22) capable of rotating centering on a shaft (for example, the shaft 21), a stator (for example, the stator 23) facing the rotor via a gap, and a tubular can (for example, the can 33) forming, on the inner side, a rotor chamber (for example, the rotor chamber 50) that houses the rotor and forming, on the outer side, a stator chamber (for example, the stator chamber 45) that houses the stator together with a motor housing (for example, the motor housing 25),
the machine learning device generating a learning model (for example, the learning model 6) used for an insulation state diagnosis device (for example, the insulation state diagnosis device 5) for diagnosing an insulation state of a winding wire (for example, the winding wire 31) of the stator used in the canned motor pump (for example, the canned motor pump 2) that circulates a part of handling liquid in the pump section to the rotor chamber, the machine learning device including:
   a learning data acquirer (for example, the learning data acquirer 121) that sets, as input data, data of a voltage value and a current value supplied to the motor section, data of the temperature of a winding wire (for example, the winding wire 31 or the coil ends 31a and 31b) of the stator or temperature (temperatures of the stator core 30, the backup sleeves 34a and 34b, the end bells 42 and 43, or the bearing holders 44 and 46), a temperature difference (for example, temperature differences of the winding wire in phases, a difference (Δt) between the temperatures in the phases of the winding wire and the temperature of the handling liquid or a difference (T5-T4) between the temperatures T4 and T5 of the front and rear backup sleeves 34a and 34b), or pressure (for example, the pressure in the stator chamber 45 or the coil end housing sections 45a and 45b) correlated with the temperature of the winding wire, and data of an inflow temperature and a flow rate of the handling liquid, the data being unprocessed data or at least partially preprocessed data, and acquires a plurality of sets of learning data including at least the input data;
   a machine learner (for example, the machine learner 122) that inputs the learning data to the learning model to cause the learning model to learn a correlation between the input data and diagnosis information of the insulation state of the winding wire; and
   a learned model storage (for example, the learned model storage 124) that stores the learning model learned by the machine learner.

Here, the input data used as the learning data is unprocessed data or at least partially preprocessed data of the following (1) to (3).
(1) the data of the voltage value and the current value supplied to the motor section,
(2) the data of the temperature of the winding wire of the stator or the temperature, the temperature difference, or the pressure correlated with the temperature of the winding wire, and
(3) the data of the inflow temperature and the flow rate of the handling liquid.
(1) to (3) described above are essential data. However, (2) only needs to be any one of
(i) the data of the temperature of the winding wire of the stator,
(ii) the data of the temperature correlated with the temperature of the winding wire of the stator,
(iii) the data of the temperature difference correlated with the temperature of the winding wire of the stator, and
(iv) the data of the pressure correlated with the temperature of the winding wire of the stator.

With this configuration, it is possible to provide a learning model capable of highly accurately inferring (estimating) diagnosis information of winding wire insulation of the motor section from data of a voltage value and a current value supplied to the motor section of the canned motor pump, data of the temperature of the winding wire of the stator of the motor section or temperature, a temperature difference, or pressure correlated with the temperature of the winding wire, data of an inflow temperature and a flow rate of the handling liquid of the pump section, the data being unprocessed data or at least partially preprocessed data. It is possible to provide a learning model capable of accurately diagnosing an insulation state of the winding wire without stopping the canned motor pump.

A second implementation mode of the present invention is the machine learning device in the first implementation mode, wherein the motor section further includes a cooling jacket (for example, the cooling jacket 71) in at least a part of the motor housing, and the input data further includes data of an inflow temperature and a flow rate of cooling liquid supplied into the cooling jacket, the data being unprocessed data or at least partially preprocessed data.

With this configuration, since the data of the inflow temperature and the flow rate of the cooling liquid, the data being the unprocessed data or the at least partially preprocessed data, is added, in addition to the input data in the first implementation mode, as the input data included in the learning data, it is possible to provide a learning model capable of more highly accurately inferring (estimating) the diagnosis information of the winding wire insulation of the motor section.

A third implementation mode of the present invention is the machine learning device in the first implementation mode, wherein the data of the voltage value and the current value supplied to the motor section is data supplied to the motor section in a predetermined period, the data of the temperature of the winding wire of the stator or the temperature, the temperature difference, or the pressure correlated with the temperature of the winding wire is data in the predetermined period, and the data of the inflow temperature and the flow rate of the handling liquid is data in the predetermined period.

With this configuration, since the data in the predetermined period is used as the input data used in the first implementation mode, it is possible to improve the accuracy of the correlation of the learning data.

A fourth implementation mode of the present invention is the machine learning device in the second implementation mode, wherein the data of the voltage value and the current value supplied to the motor section is data supplied to the motor section in a predetermined period, the data of the temperature of the winding wire of the stator or the temperature, the temperature difference, or the pressure correlated with the temperature of the winding wire is data in the predetermined period, the data of the inflow temperature and the flow rate of the handling liquid is data in the predetermined period, and the data of the inflow temperature and the flow rate of the cooling liquid supplied into the cooling jacket is data in the predetermined period.

With this configuration, since the data in the predetermined period is used as the input data used in the second implementation mode, it is possible to improve the accuracy of the correlation of the learning data.

A fifth implementation mode of the present invention is the machine learning device in any one of the first to fourth implementation modes, wherein the learning data further includes, as output data, the diagnosis information associated with the input data and indicating that the insulation state of the winding wire is any one of a plurality of states, and the machine learner causes the learning model to learn, with supervised learning, a correlation between the input data and the output data.

With this configuration, it is possible to generate a learning model caused to learn, with the supervised learning, the correlation between the input data and the diagnosis information of the insulation state of the winding wire.

A sixth implementation mode of the present invention is the machine learning device in any one of the first to fourth implementation modes, wherein the learning data includes only input data at a time when the diagnosis information indicates that the insulation state of the winding wire is a predetermined state, and the machine learner causes the learning model to learn, with unsupervised learning, a correlation between the input data and the diagnosis information indicating that the insulation state of the winding wire is the predetermined state.

With this configuration, it is possible to generate a learning model caused to learn, with the unsupervised learning, the correlation between the input data and the diagnosis information of the insulation state of the winding wire.

A seventh implementation mode of the present invention is an insulation state diagnosis device (for example, the insulation state diagnosis device 5) for diagnosing an insulation state of the winding wire of the stator used in the canned motor pump using the learning model generated by the machine learning device in any one of the first to sixth implementation modes, the insulation state diagnosis device including:
an input data acquirer (for example, the input data acquirer 141) that acquires input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid and including data of an inflow temperature and a flow rate of cooling liquid when necessary, the data being unprocessed data or at least partially preprocessed data; and
an inferer (for example, the inferer 142) that inputs the input data acquired by the input data acquirer to the learning model and infers diagnosis information of the insulation state of the winding wire of the stator.
With this configuration, since the diagnosis information of the insulation state of the winding wire of the stator can be inferred using the input data including the data of the voltage value and the current value supplied to the motor section, the data of the temperature of the winding wire of the stator or the temperature, the temperature difference, or the pressure correlated with the temperature of the winding wire, and the data of the inflow temperature and the flow rate of the handling liquid and including the data of the inflow temperature and the flow rate of the cooling liquid when necessary, the data being the unprocessed data or the at least partially preprocessed data, it is possible to highly accurately diagnose the insulation state of the winding wire without stopping a plant.

An eighth implementation mode of the present invention is a machine learning method of learning a learning model used for an insulation state diagnosis device that diagnoses a canned motor pump including, a motor section, and a pump section driven by the motor section,
the motor section including, a rotor capable of rotating centering on a shaft, a stator facing the rotor via a gap, and a tubular can forming, on an inner side, a rotor chamber that houses the rotor and forming, on an outer side, a stator chamber that houses the stator in conjunction with a motor housing,
the insulation state diagnosis device being for diagnosing an insulation state of a winding wire of the stator used in the canned motor pump that circulates a part of handling liquid in the pump section to the rotor chamber, the machine learning method including:
   a learning data acquisition step (for example, the processing S100 and S300) of setting, as input data, data of a voltage value and a current value supplied to the motor section, data of temperature of a winding wire of the stator or temperature, a temperature difference, or pressure correlated with the temperature of the winding wire, and data of an inflow temperature and a flow rate of the handling liquid, the data being unprocessed data or at least partially preprocessed data, and acquiring a plurality of sets of learning data including at least the input data;
   a machine learning step (for example, the processing S110 and S310) of inputting the learning data to the learning model to cause the learning model to learn a correlation between the input data and diagnosis information of the insulation state of the winding wire; and
   a learned model storing step (for example, the processing S130 and S330) of storing the learning model learned by the machine learning step in a learned model storage.

With this configuration, it is possible to provide a learning model capable of highly accurately inferring (estimating) diagnosis information of winding wire insulation of the motor section from data of a voltage value and a current value supplied to the motor section of the canned motor pump, data of the temperature of the winding wire of the stator of the motor section or temperature, a temperature difference, or pressure correlated with the temperature of the winding wire, data of an inflow temperature and a flow rate of the handling liquid of the pump section, the data being unprocessed data or at least partially preprocessed data. It is possible to provide a learning model capable of accurately diagnosing an insulation state of the winding wire without stopping the canned motor pump.

A ninth implementation mode of the present invention is the machine learning method in the eighth implementation mode, wherein the motor section further includes a cooling jacket in at least a part of an outer circumference of the motor housing, and
the input data further includes data of an inflow temperature and a flow rate of cooling liquid supplied into the cooling jacket, the data being unprocessed data or at least partially preprocessed data.

With this configuration, since the data of the inflow temperature and the flow rate of the cooling liquid, the data being the unprocessed data or the at least partially preprocessed data, is added, in addition to the input data in the eighth implementation mode, as the input data included in the learning data, it is possible to provide a learning model capable of more highly accurately inferring (estimating) the diagnosis information of the winding wire insulation of the motor section.

A tenth implementation mode of the present invention is a machine learning program for causing a computer to execute the steps included in the machine learning method described in the eighth or ninth implementation mode.

With this configuration, it is possible to provide a learning model capable of highly accurately inferring (estimating) diagnosis information of winding wire insulation of the motor section from data of a voltage value and a current value supplied to the motor section of the canned motor pump, data of the temperature of the winding wire of the stator of the motor section or temperature, a temperature difference, or pressure correlated with the temperature of the winding wire, and data of an inflow temperature and a flow rate of the handling liquid of the pump section and from data of an inflow temperature and a flow rate of the cooling liquid when necessary, the data being unprocessed data or at least partially preprocessed data. It is possible to provide a learning model capable of accurately diagnosing an insulation state of the winding wire without stopping the canned motor pump.

An eleventh implementation mode of the present invention is an insulation state diagnosis method of diagnosing, using a learning model generated by the machine learning device described in any one of the first to sixth implementation modes, an insulation state of the winding wire of the stator used in the canned motor pump, the insulation state diagnosis method including:
an input data acquisition step (for example, the processing S200 and S400) of acquiring input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid and including data of an inflow temperature and a flow rate of cooling liquid when necessary, the data being unprocessed data or at least partially preprocessed data; and
an inferring step (the processing S210 and S410) of inputting the input data acquired by the input data acquisition step to the learning model and inferring diagnosis information of the insulation state of the winding wire of the stator.

With this configuration, it is possible to highly accurately infer (estimate) diagnosis information of the winding wire insulation of the motor section using data of a voltage value and a current value supplied to the motor section, data of temperature of the winding wire of the stator or temperature, a temperature difference, or pressure correlated with the temperature of the winding wire, and data of an inflow temperature and a flow rate of the handling liquid and including data of an inflow temperature and a flow rate of the cooling liquid when necessary, the data being unprocessed data or at least partially preprocessed data. It is possible to accurately diagnose an insulation state of the winding wire without stopping the canned motor pump.

A twelfth implementation mode of the present invention is an insulation state diagnosis program for causing a computer to execute the steps included in the insulation state diagnosis method described in the eleventh implementation mode.

With this configuration, it is possible to highly accurately infer (estimate) diagnosis information of winding wire insulation of the motor section from input data including data of a voltage value and a current value supplied to the motor section of the canned motor pump, data of the temperature of the winding wire of the stator of the motor section or temperature, a temperature difference, or pressure correlated with the temperature of the winding wire, and data of an inflow temperature and a flow rate of the handling liquid of the pump section and including data of an inflow temperature and a flow rate of the cooling liquid when necessary, the data being unprocessed data or at least partially preprocessed data. It is possible to accurately diagnose an insulation state of the winding wire without stopping the canned motor pump.

### Reference Signs List

- 1: insulation state diagnosis system
- 2: canned motor pump
- 3: measurement device
- 4: machine learning device
- 5: insulation state diagnosis device
- 6: learning model
- 10: pump section
- 20: motor section
- 21: shaft
- 22: rotor
- 23: stator
- 25: motor housing
- 31: winding wire
- 33: can
- 45: stator chamber
- 50: rotor chamber
- 71: cooling jacket
- 101: motor voltage/current sensor
- 102: winding wire heat generation state measurement sensor
- 103: handling liquid measurement sensor
- 104: cooling liquid measurement sensor
- 121: learning data acquirer
- 122: machine learner
- 123: learning data storage
- 124: learned model storage
- 141: input data acquirer
- 142: inferer
- 143: output processor
- 144: learned model storage

## Claims

1. A machine learning device, wherein a canned motor pump includes, a motor section, and a pump section driven by the motor section,
the motor section including, a rotor capable of rotating centering on a shaft, a stator facing the rotor via a gap, and a tubular can forming, on an inner side, a rotor chamber that houses the rotor and forming, on an outer side, a stator chamber that houses the stator in conjunction with a motor housing,
the machine learning device generating a learning model used for an insulation state diagnosis device for diagnosing an insulation state of a winding wire of the stator used in the canned motor pump that circulates a part of handling liquid in the pump section to the rotor chamber, the machine learning device comprising:
a learning data acquirer that sets, as input data, data of a voltage value and a current value supplied to the motor section, data of temperature of a winding wire of the stator or temperature, a temperature difference, or pressure correlated with the temperature of the winding wire, and data of an inflow temperature and a flow rate of the handling liquid, the data being unprocessed data or at least partially preprocessed data, and acquires a plurality of sets of learning data including at least the input data;
a machine learner that inputs the learning data to the learning model to cause the learning model to learn a correlation between the input data and diagnosis information of the insulation state of the winding wire; and
a learned model storage that stores the learning model learned by the machine learner.

2. The machine learning device according to claim 1, wherein
the motor section further includes a cooling jacket in at least a part of the motor housing, and
the input data further includes data of an inflow temperature and a flow rate of cooling liquid supplied into the cooling jacket.

3. The machine learning device according to claim 1, wherein
the data of the voltage value and the current value supplied to the motor section is data supplied to the motor section in a predetermined period,
the data of the temperature of the winding wire of the stator or the temperature, the temperature difference, or the pressure correlated with the temperature of the winding wire is data in the predetermined period, and
the data of the inflow temperature and the flow rate of the handling liquid is data in the predetermined period.

4. The machine learning device according to claim 2, wherein
the data of the voltage value and the current value supplied to the motor section is data supplied to the motor section in a predetermined period,
the data of the temperature of the winding wire of the stator or the temperature, the temperature difference, or the pressure correlated with the temperature of the winding wire is data in the predetermined period,
the data of the inflow temperature and the flow rate of the handling liquid is data in the predetermined period, and
the data of the inflow temperature and the flow rate of the cooling liquid supplied into the cooling jacket is data in the predetermined period.

5. The machine learning device according to any one of claims 1 to 4, wherein
the learning data further includes, as output data, the diagnosis information associated with the input data and indicating that the insulation state of the winding wire is any one of a plurality of states, and
the machine learner causes the learning model to learn, with supervised learning, a correlation between the input data and the output data.

6. The machine learning device according to any one of claims 1 to 4, wherein
the learning data includes only input data at a time when the diagnosis information indicates that the insulation state of the winding wire is a predetermined state, and
the machine learner causes the learning model to learn, with unsupervised learning, a correlation between the input data and the diagnosis information indicating that the insulation state of the winding wire is the predetermined state.

7. An insulation state diagnosis device for diagnosing an insulation state of the winding wire of the stator used in the canned motor pump using the learning model generated by the machine learning device according to claim 1 or 3, the insulation state diagnosis device comprising:
an input data acquirer that acquires input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid, the data being unprocessed data or at least partially preprocessed data; and
an inferer that inputs the input data acquired by the input data acquirer to the learning model and infers diagnosis information of the insulation state of the winding wire of the stator.

8. An insulation state diagnosis device for diagnosing an insulation state of the winding wire of the stator used in the canned motor pump using the learning model generated by the machine learning device according to claim 2 or 4, the insulation state diagnosis device comprising:
an input data acquirer that acquires input data including data of a voltage value and a current value supplied to the motor section, data of temperature of the winding wire of the stator or temperature, a temperature difference, or pressure correlated with the temperature of the winding wire, data of an inflow temperature and a flow rate of the handling liquid, and data of an inflow temperature and a flow rate of cooling liquid, the data being unprocessed data or at least partially preprocessed data; and
an inferer that inputs the input data acquired by the input data acquirer to the learning model and infers diagnosis information of the insulation state of the winding wire of the stator.

9. A machine learning method of learning a learning model used for an insulation state diagnosis device that diagnoses a canned motor pump including, a motor section, and a pump section driven by the motor section,
the motor section including, a rotor capable of rotating centering on a shaft; a stator facing the rotor via a gap; and a tubular can forming, on an inner side, a rotor chamber that houses the rotor and forming, on an outer side, a stator chamber that houses the stator in conjunction with a motor housing,
the insulation state diagnosis device being for diagnosing an insulation state of a winding wire of the stator used in the canned motor pump that circulates a part of handling liquid in the pump section to the rotor chamber, the machine learning method comprising:
a learning data acquisition step of setting, as input data, data of a voltage value and a current value supplied to the motor section, data of temperature of a winding wire of the stator or temperature, a temperature difference, or pressure correlated with the temperature of the winding wire, and data of an inflow temperature and a flow rate of the handling liquid, the data being unprocessed data or at least partially preprocessed data, and acquiring a plurality of sets of learning data including at least the input data;
a machine learning step of inputting the learning data to the learning model to cause the learning model to learn a correlation between the input data and diagnosis information of the insulation state of the winding wire; and
a learned model storing step of storing the learning model learned by the machine learning step in a learned model storage.

10. The machine learning method according to claim 9, wherein the motor section further includes a cooling jacket in at least a part of an outer circumference of the motor housing, and
the input data further includes data of an inflow temperature and a flow rate of cooling liquid supplied into the cooling jacket.

11. A machine learning program for causing a computer to execute the steps included in the machine learning method according to claim 9 or 10.

12. An insulation state diagnosis method of diagnosing, using a learning model generated by the machine learning device according to claim 1 or 3, an insulation state of the winding wire of the stator used in the canned motor pump, the insulation state diagnosis method comprising:
an input data acquisition step of acquiring input data including data of a voltage value and a current value supplied to the motor section, data of temperature of the winding wire of the stator or temperature, a temperature difference, or pressure correlated with the temperature of the winding wire, and data of an inflow temperature and a flow rate of the handling liquid, the data being unprocessed data or at least partially preprocessed data; and
an inferring step of inputting the input data acquired by the input data acquisition step to the learning model and inferring diagnosis information of the insulation state of the winding wire of the stator.

13. An insulation state diagnosis method of diagnosing, using a learning model generated by the machine learning device according to claim 2 or 4, an insulation state of the winding wire of the stator used in the canned motor pump, the insulation state diagnosis method comprising:
an input data acquisition step of acquiring input data including data of a voltage value and a current value supplied to the motor section, data of temperature of the winding wire of the stator or temperature, a temperature difference, or pressure correlated with the temperature of the winding wire, data of an inflow temperature and a flow rate of the handling liquid, and data of an inflow temperature and a flow rate of the cooling liquid, the data being unprocessed data or at least partially preprocessed data; and
an inferring step of inputting the input data acquired by the input data acquisition step to the learning model and inferring diagnosis information of the insulation state of the winding wire of the stator.

14. An insulation state diagnosis program for causing a computer to execute the steps included in the insulation state diagnosis method according to claim 12.

15. An insulation state diagnosis program for causing a computer to execute the steps included in the insulation state diagnosis method according to claim 13.
